# EUROPEAN PATENT APPLICATION

(11) **EP 1 785 888 A2**
(43) Date of publication of application: **16.05.2007**
(21) Application number: 06123413.4
(22) Date of filing: 03.11.2006
(51) Int. Cl.: G06F 17/00

(54) **Internal-combustion engine design support system**

(30) Priority: 07.11.2005 JP 2005322535; 07.11.2005 JP 2005322536; 26.12.2005 JP 2005373064; 26.12.2005 JP 2005373065
(71) Applicant: Mazda Motor Corporation, Aki-gun, Hiroshima 730-8670 (JP)
(72) Inventor: Yokohata, Hideaki Mazda Motor Corporation, Hiroshima 730-8670 (JP); Kusunoki, Yasutomo Mazda Motor Corporation, Hiroshima 730-8670 (JP)
(74) Representative: Zinnecker, Armin

(57) **Abstract**

Disclosed is an internal-combustion engine design support system for presenting a combination of functional specification types or the like of a design-target engine in connection with a target performance parameter value set out in a new vehicle. The system comprises a database (1) storing data about a design parameter value of a given design parameter, a functional specification type of a given functional specification, and a performance parameter value of a given performance parameter, which are associated with each of a plurality of existing internal-combustion engines, a performance calculation section (21) for calculating a performance parameter value of the given performance parameter of at least one of an internal-combustion engine model set by changing a combination of a reference design parameter value and/or a reference functional specification type of a base internal-combustion engine selected from the existing internal-combustion engines, and a combination presentation section (22) for outputting at least one combination of a design parameter value and a functional specification type of the internal-combustion engine model having the performance parameter value calculated by the performance calculation section (21), according to a given presentation condition.

## Description

### BACKGROUND OF THE INVENTION

### 1. Field of the Invention

The present invention relates to a computer-aided internal-combustion engine design support system, and more specifically to an internal-combustion engine design support system for presenting a combination of functional specification types or the like of a design-target internal-combustion engine, in connection with a target performance parameter value set out in a new vehicle, so as to support the design of the internal-combustion engine.

### 2. Description of the Related Art

Japanese Patent Laid-Open Publication No. 2005-100054 discloses a design support system for designing an internal-combustion engine, such as an engine piston or an engine intake port, using 3D CAD (3-dimensional computer-aided design) software, so as to promote the efficiency of the engine design.

Generally, in a planning stage of a new vehicle, various target performance parameter values are set out for respective performance parameters, such as engine performances and mileage performance, of the new vehicle, to develop a superior position in marketing to competing vehicles (benchmark vehicles). In anticipation of upgrade of the benchmark vehicles at the time of release of the new vehicle, these target performance parameter values are typically set higher than corresponding performance parameter values of existing vehicles at the time of the planning. Therefore, it is necessary for product-development departments to design the new vehicle to achieve the higher target performance parameter values.

Further, a plurality of vehicle factors generally contribute to each vehicle performance parameter. For example, a mileage performance of a vehicle is affected by not only a fuel consumption rate of an internal-combustion engine itself but also a transmission gear ratio of a powertrain, a tire rolling resistance, a vehicle weight and other contributing factors. Thus, a plurality of product-development departments are typically involved in each of the target performance parameters.

In reality, an objective/technical basis or criterion for determining how to share the responsibility of achieving the target performance parameter values, i.e., how much each of the product-development departments improves responsible factors contributing to the target performance parameter values, has not been always clear. For example, a criterion for determining how much each of the product-development departments improves individual contributing factors, such as engine fuel consumption rate or vehicle weight, to achieve the target performance parameter value about vehicle mileage has not been clear.

Technical contents to be developed by the respective product-development departments are totally different from each other, and design tasks in the product-development departments are carried out independently. Thus, in some cases, it turns out that the target performance parameter values are not achieved as the entire new vehicle, only after release of design drawings from the respective product-development departments. This is likely to cause the need for redoing design tasks in the product-development departments, and deterioration in development efficiency of the new vehicle.

In the design of an internal-combustion engine using a conventional CAD or the like, a design parameter value of a given design parameter, such as engine displacement, a functional specification type of a given functional specification, such as a fuel injection system, and a performance parameter value of a given performance parameter, have not been always correlated with each other. Thus, if the design parameter value or the functional specification type of the engine is changed, it is difficult to design the engine while figuring out a level of impact of the change on the performance parameter value.

Particularly, in the design process of a new vehicle, a cost reduction is an absolute prerequisite to maintain price competitiveness in a volume zone. Thus, each of the product-development departments is required to carry out their design tasks under severe restrictions on cost.

Generally, if a high-performance functional specification type is employed to achieve a target performance parameter value, it will lead to an increase in cost. For example, while a supercharger may be employed as a means to provide higher low-speed torque to an internal-combustion engine, the engine employing the supercharger will be inevitably increased in cost as compared with an internal-combustion engine without the supercharger.

Thus, in a process of designing a new vehicle meeting target performance parameter values under restrictions on cost, it is often the case that a high level of managerial judgment is necessary to determine whether a specific functional specification type should be employed in an internal-combustion engine.

In such a determination on whether a specific functional specification type should be employed in the engine, an adequate objective/technical criterion therefor has not been always ensured.

Moreover, as mentioned above, in the design of an internal-combustion engine using a conventional CAD or the like, a design parameter value of a given design parameter, such as engine displacement, a functional specification type of a given functional specification, such as a fuel injection system, and a performance parameter value of a given performance parameter, have not been always correlated with each other. Thus, if the design parameter value or the functional specifications type of the engine is changed, it is difficult to design the engine while figuring out a level of impact of the change on the performance parameter value.

### SUMMARY OF THE INVENTION

It is therefore an object of the present invention to provide an internal-combustion engine design support system capable of improving the efficiency of design of an internal-combustion engine.

It is another object of the present invention to provide an internal-combustion engine design support system capable of presenting a combination of functional specification types or the like of a design-target internal-combustion engine, in connection with a target performance parameter value set out in a new vehicle.

It is yet another object of the present invention to provide an internal-combustion engine design support system capable of carrying out the design of an internal-combustion engine while verifying an impact of a change in design parameter value or functional specification type on a performance parameter value.

It is still another object of the present invention to provide an internal-combustion engine design support system capable of presenting a criterion for determining whether a specific functional specification type or the like should be employed in a design-target internal-combustion engine, in connection with a target performance parameter value set out in a new vehicle.

It is yet still another object of the present invention to provide an internal-combustion engine design support system capable of carrying out the design of an internal-combustion engine while verifying an impact of a change in design parameter value or functional specification type on a balance between a plurality of performance parameter values.

In order to achieve the above objects, the present invention provides an internal-combustion engine design support system which comprises: a database storing data about a design parameter value of a given design parameter, a functional specification type of a given functional specification, and a performance parameter value of a given performance parameter, which are associated with each of a plurality of existing internal-combustion engines; performance calculation means for calculating a performance parameter value of the given performance parameter of at least one of an internal-combustion engine model set by changing a combination of a reference design parameter value and/or a reference functional specification type of a base internal-combustion engine selected from the existing internal-combustion engines; and combination presentation means for outputting at least one combination of a design parameter value and a functional specification type of the internal-combustion engine model having the performance parameter value calculated by the performance calculation means, according to a given presentation condition.

According to the above internal-combustion engine design support system of the present invention, a plurality of internal-combustion engine models having various combinations can be represented according to a given presentation condition. This makes it possible to present a combination of functional types or the like for a design-target engine of a new vehicle, in connection with a target performance parameter value set out in the new vehicle. Further, in order to achieve the target performance parameter value, the presented combination of functional types or the like of the internal-combustion engine model can be used as an objective/technical criterion for determining tasks to be assigned to product-development departments concerning internal-combustion engines or determining a performance of each factor of the design-target engine assigned to each of the product-development departments. In addition, according to the present invention, a combination of a design parameter value and a functional specification type of the design-target engine can also be determined based on the content of the presented combination. This makes it possible to readily determine a direction of the design of the internal-combustion engine so as to promote the efficiency of the design of the internal-combustion engine.

Preferably, in the present invention, the given functional specification stored as the functional specification type in the database includes at least one selected from the group consisting of with/without a supercharger, a fuel injection system, standard fuel, with/without a variable valve control mechanism, a valve drive mechanism and the number of intake/exhaust valves. A change in a functional specification type of the functional specification has great impact on various performance parameter values of the design-target engine.

Preferably, in the present invention, the given design parameter stored as the design parameter value in the database includes engine displacement. A change in a design parameter value of the design parameter has great impact on various performance parameter values of the design-target engine.

Preferably, in the present invention, the given performance parameter to be calculated by the performance calculation means includes fuel consumption rate. This performance parameter is a critical factor in engine design.

Preferably, in the present invention, the performance calculation means is operable to calculate a performance parameter value of the given performance parameter for all combinations of a plurality of design parameter values of the given design parameter and a plurality of functional specification types of the given functional specification, under a given constraint condition. Thus, the calculation can be performed for all of the combinations to study all alternatives or possible combinations for achieving the target performance parameter values, without omission

Preferably, in the present invention, the given presentation condition for the combination presentation means includes presentation in ascending order of cost and presentation in descending order of performance parameter value.

Thus, a combination of a design parameter value and a functional specification type of the internal-combustion engine model can be present in ascending order of cost to schematically shown a functional specification or the like of the design-target engine to be designed at lower cost, in connection with the target performance parameter values set out in the new vehicle. Further, the combination of the design parameter value and the functional specification type of the internal-combustion engine model can also be present in descending order of performance parameter value to schematically shown a functional specification or the like of the design-target engine to be designed in higher performance, in connection with the target performance parameter values set out in the new vehicle.

Preferably, in the present invention, the combination presentation means is operable to selectively present only a combination of a design parameter value and a functional specification type of the internal-combustion engine model which has a performance parameter value meeting a target performance parameter value, or to present a combination of a design parameter value and a functional specification type of the internal-combustion engine model, internal-combustion engine models, with discrimination whether a performance parameter value of said combination meets a target performance parameter value.

This makes it possible to readily figure out what a functional specification type or the like is necessary to achieve the target performance parameter value.

Preferably, in the present invention, the combination presentation means is operable to display, on display means, a relation map which represents a combination of a design parameter value and a functional specification type, or a combination of respective performance parameter values of a plurality of performance parameters, in the form of a combination of respective parameters of coordinate axes, while plotting, on the relation map, a reference performance parameter value of the base internal-combustion engine, a target performance parameter value set out in a design-target internal-combustion engine, and the performance parameter value calculated by the performance calculation means.

According to the internal-combustion engine design support system configured as above, a post-change performance parameter value, which is a performance parameter value of the internal-combustion engine model set by changing a reference design parameter value and/or a reference functional specification type of the base internal-combustion engine selected from the existing internal-combustion engines, is calculated. This makes it possible to design the design-target engine while verifying an impact of a change in design parameter value and/or functional specification type of the design-target engine.

Further, the relation map which represents a combination of a design parameter value and a functional specification type, or a combination of respective performance parameter values of a plurality of the given performance parameters, in the form of a combination of respective parameters of coordinate axes, can be presented, and the reference performance parameter value, the target performance parameter value and the post-change performance parameter value are plotted on the relation map. This makes it possible to readily figure out a relationship between the performance parameter values and a relationship between the performance parameter value and the design parameter value. In particular, when the functional specification value or the like is changed, a relationship between the post-change performance parameter value and the reference performance parameter value/the target performance parameter value can be readily figured out.

Preferably, in the present invention, the combination presentation means is operable to display the relation map while plotting thereon a performance parameter value of at least one of the existing internal-combustion engines.

Thus, the performance parameter values of the existing internal-combustion engines can be plotted on the relation map to readily figure out a position of the target performance parameter value of the design-target engine, the post-change performance parameter value and the reference performance parameter value, in a distribution of performance parameter values of the existing internal-combustion engines.

Preferably, in the present invention, the combination presentation means is operable to display the relation map while plotting thereon a plurality of performance parameter values of the existing internal-combustion engines in such a manner that the performance parameter values are grouped on the basis of a combination of two or more functional specification types.

This grouped presentation makes it possible to design the design-target engine with reference to a combination of functional specification types of the group capable of achieving the target performance parameter value. For example, a combination of functional specification types of the existing internal-combustion engine in the group meeting the target performance parameter value can be compared with a combination of functional specification types of the base internal-combustion engine to find a difference therebetween. This makes it possible to know that the target performance value can be achieved by correcting the difference in functional specification type, with a high probability. This comparison also allows an operator to recognize that he target performance value is hardly achieved by the combination of functional specification types of the base internal-combustion engine, and the combination of functional specification types of the base internal-combustion engine has to be changed.

Preferably, in the present invention, the combination presentation means is operable to display the relation map in such a manner that coordinate axes thereof represent engine displacement as the design parameter and fuel consumption rate as the performance parameter, respectively.

This makes it possible to design the design-target engine while figuring out a relationship between a fuel consumption rate value and an engine displacement value based on the relation map.

Preferably, in the present invention, the combination presentation means is operable to display the relation map in such a manner that coordinate axes thereof represent maximum power as the performance parameter and fuel consumption rate as the performance parameter, respectively.

This makes it possible to design the design-target engine while figuring out a relationship between a maximum power value and a fuel consumption rate value based on the relation map.

Preferably, in the present invention, the design parameter includes engine displacement. A change in a design parameter value of this design parameter has great impact on various performance parameter values of the design-target engine.

Preferably, in the present invention, the performance calculation means is operable to calculate a cost parameter value of a given cost parameter in addition to the performance parameter value of the given performance parameter, and the combination presentation means is operable to display, on display means, a relation map having at least two coordinate axes which represents, respectively, the given performance parameter and the given cost parameter for each of a plurality of the internal-combustion engine models, while plotting, on the relation map, a reference performance parameter value of the given performance parameter and a cost parameter value of given cost parameter of each of the internal-combustion engine models, together with an indicator representing a target performance parameter value.

According to the internal-combustion engine design support system configured as above, the performance parameter value and the cost parameter value of the internal-combustion model can be plotted on the relation map. This makes it possible to readily figure out a relationship between a combination of functional specification types or the like and the cost parameter value, in connection with the target performance value and an allowable engine cost. Thus, the relation map can be used as a criterion for determining whether a specific functional specification type should be employed in the design-target engine, in connection with the target performance value set out in the new vehicle.

Preferably, in the present invention, the combination presentation means is operable to indicate, on the relation map, respective plots of the internal-combustion engine models, with discrimination whether a specific functional specification type is employed in each of the internal-combustion engine models. This makes it possible to readily figure out a situation on achievement of the target performance value and a tendency of the cost parameter value.

Preferably, in the present invention, the combination presentation means is operable to indicate, on the relation map, an indicator representing a specific engine cost value. This makes it possible to readily figure out whether the calculated cost parameter value of the internal-combustion engine model is within an initial budget.

Preferably, in the present invention, the combination presentation means is operable to display, on display means, a radar chart having a plurality of coordinate axes which represent, respectively, a plurality of performance parameters, while plotting, on the radar chart, post-change performance parameter values calculated by the performance calculation means.

According to the internal-combustion engine design support system configured as above, respective post-change performance parameter values of a plurality of performance parameters are calculated in response to a change in design parameter value or the like of the internal-combustion engine model, and the calculated post-change performance parameter values are indicated on the radar chart individually. This makes it possible to design the design-target engine while verifying an impact of a change in design parameter value and/or functional specification type of the design-target engine on a balance between the performance parameter values.

Preferably, in the present invention, the combination presentation means is operable to indicate a target performance parameter value for each of the performance parameters, on the radar chart.

This makes it possible to readily compare the performance parameter value with the target performance parameter value on a performance parameter-by-performance parameter basis so as to readily figure out the level of achievement of the target performance parameter value on a performance parameter-by-performance parameter basis.

Preferably, in the present invention, the combination presentation means is operable to display a lower-layer radar chart for each of the performance parameters on the coordinate axes of the radar chart serving as an upper-layer radar chart. The lower-layer radar chart has a plurality of coordinate axes which represent, respectively, a plurality of detailed-performance parameters interacting with a performance parameter value of the performance parameter.

Thus, the lower-layer radar chart can be displayed to readily figure out a balance between the performance parameter values on a detailed-performance parameter-by-detailed-performance parameter basis.

Preferably, in the present invention, the performance calculation means is operable, when the performance parameter value of the performance parameter on either one of the coordinate axes of the upper-layer radar chart, to calculate respective post-change performance parameter values of the detailed-performance parameters to be affected by the change in the performance parameter value of the performance parameter, and the combination presentation means is operable to indicate the calculated post-change performance parameter values on the lower-layer radar chart having the coordinate axes representing the detailed-performance parameters.

Thus, the performance parameter values of the detailed-performance parameters in the lower-layer radar chart can be changed in conjunction with the change in the performance parameter value in the upper-layer radar chart to readily figure out not only a balance between the performance parameter values of the performance parameters in the upper-layer radar chart including the changed performance parameter value but also a balance between the performance parameter values of the detailed-performance parameters in the lower-layer radar chart associated with each of the performance parameters.

Preferably, in the present invention, the performance calculation means is operable, when the performance parameter value of the detailed-performance parameter on either one of the coordinate axes of the lower-layer radar chart, to calculate a post-change performance parameter value of the performance parameter to be affected by the change in the performance parameter value of the detailed-performance parameter, and the combination presentation means is operable to indicate the calculated post-change performance parameter value on the upper-layer radar chart having the coordinate axes representing the performance parameters.

Thus, the performance parameter value in the upper-layer radar chart can be changed in conjunction with the change in the performance parameter value of the detailed-performance parameter in the lower-layer radar chart to readily figure out not only a balance between the performance parameter values of the detailed performance parameters in the lower-layer radar chart including the changed performance parameter value but also a balance between the performance parameter values of the performance parameters in the upper-layer radar chart.

The above and other objects and features of the present invention will be apparent from the following description by taking reference with accompanying drawings employed for preferred embodiments of the present invention.

### BRIEF DESCRIPTION OF THE DRAWINGS

In the accompanying drawings:
FIG. 1 is a block diagram showing the configuration of an internal-combustion engine design support system according to a first embodiment of the present invention;
FIGS. 2(a) and 2(b) are diagrams showing an example of presentation of a combination of a design parameter value and a functional specification type in the first embodiment;
FIG. 3 is a block diagram showing the configuration of an internal-combustion engine design support system according to a second embodiment of the present invention;
FIGS. 4(a) and 4(b) are diagrams showing a relation map having coordinate axes representing maximum power and fuel consumption rate, in the second embodiment;
FIG. 5 is a diagram showing a list of a design parameter value/functional specification type and a performance parameter value, in the second embodiment;
FIG. 6 is a diagram showing a relation map having coordinate axes representing total engine displacement and fuel consumption rate, in the second embodiment;
FIG. 7 is a diagram showing a relation map having coordinate axes representing low-speed torque and cost, in a third embodiment of the present invention;
FIG. 8 is a diagram showing a design parameter value and a functional specification type corresponding to a plot selected from the relation map in FIG. 7;
FIG. 9 is a diagram showing a radar chart in a fourth embodiment of the present invention;
FIG. 10 is a diagram showing an example of a lower (second)-layer radar chart associated with a performance parameter "low-speed torque" in the radar chart in FIG. 9;
FIG. 11 is a diagram showing an example of a lower (third)-layer radar chart associated with the lower-layer radar chart in FIG. 10; and
FIG. 12 is a diagram showing another example of the lower (third)-layer radar chart associated with the lower-layer radar chart in FIG. 10.

### DETAILED DESCRIPTION OF THE PREFERRED EMBODIMENTS OF THE INVENTION

A preferred embodiment of the present invention will now be described with reference to the drawings.

### [FIRST EMBODIMENT]

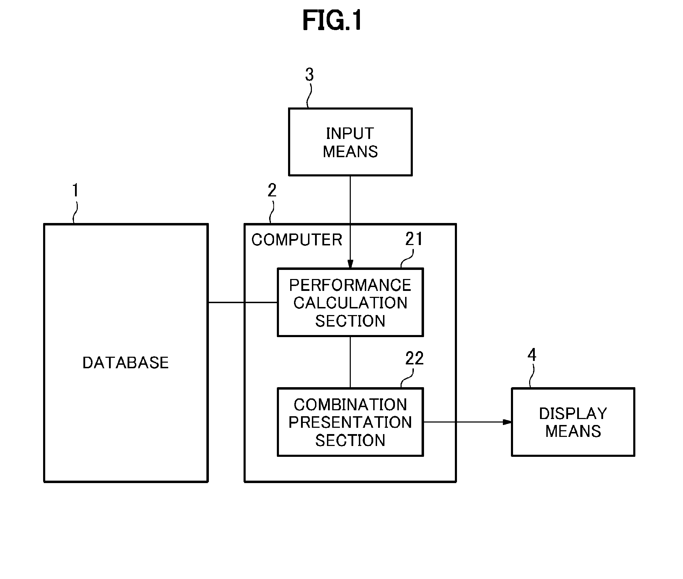

With reference to FIG. 1, the configuration of an internal-combustion engine design support system according to a first embodiment of the present invention will be described below.

As shown in FIG. 1, the internal-combustion engine design support system according to this embodiment comprises a database 1 storing data for use in designing an internal-combustion engine (hereinafter referred to simply as "engine") of a vehicle, and a computer 2 for supporting the design of the engine by use of the data stored in the database 1. The computer 2 is connected to input means 3, such as a keyboard, and display means 4, such as a display.

The database 1 stores a design parameter value of a given design parameter, a functional specification type of a given functional specification, and a performance parameter value of a given performance parameter, which are associated with each of a plurality of existing engines. In this embodiment, the given design parameter may include engine displacement, and cylinder bore x stroke. The given functional specification may include: with/without a supercharger, such as a turbocharger, (including a supercharged type and a non-supercharged type); a fuel injection system [including, for example, an individual injection type (port + sequential injection), a port injection type (port + simultaneous injection) and a direct injection type], a standard fuel (including, for example, premium gasoline and regular gasoline); with/without a variable valve timing (VVT) mechanism (including a non-variable type and a variable type); a valve drive mechanism [including, for example, an OHC (overhead camshaft) type, an SOHC (single overhead camshaft) type or a DOHC (double overhead camshaft) type]; and the number of intake/exhaust valves (including a two-valve type and a multi-valve type such as two intake valves/two exhaust valves). Further, the given performance parameter may include a fuel consumption rate, a maximum torque, a maximum power, and an emission performance, such as nitrogen-oxides or carbon-monoxide emission performance.

The database 1 further stores a function formula for use in calculating a performance parameter value corresponding to a changed design parameter value and/or a changed functional specification type. The function formula includes a function based on theories and a function based on previously-accumulated empirical rules.

The computer 2 includes a performance calculation section 21 and a combination presentation section 22. The performance calculation section 21 and the combination presentation section 22 represent processing functions corresponding, respectively, to performance calculation means and combination presentation means in the internal-combustion engine design support system of the present invention. These processing functions are achieved by execution of a given program in the computer 2.

The performance calculation section 21 of the computer 2 is operable to calculate a performance parameter value of the given performance parameter of at least one engine model set by changing a combination of a reference design parameter value and/or a reference functional specification type of a base engine selected from the existing engines. The base engine is selected from the existing engines by an operator through the use of the input means 3. For example, an engine of an existing vehicle to be remodeled as a new vehicle may be selected as the base engine.

A performance parameter value of the given performance parameter of the base engine is stored in the database 1. In an operation of calculating a post-change performance parameter value in response to a change in design parameter value and/or performance parameter value, the performance parameter value of the base engine is changed using the function formula stored in the database 1 to obtain the post-change performance parameter value.

The combination presentation section 22 of the computer 2 is operable to output at least one combination of a design parameter value and a functional specification type of the engine model having the performance parameter value calculated by the performance calculation section 21, onto the display means 4 according to a given presentation condition.

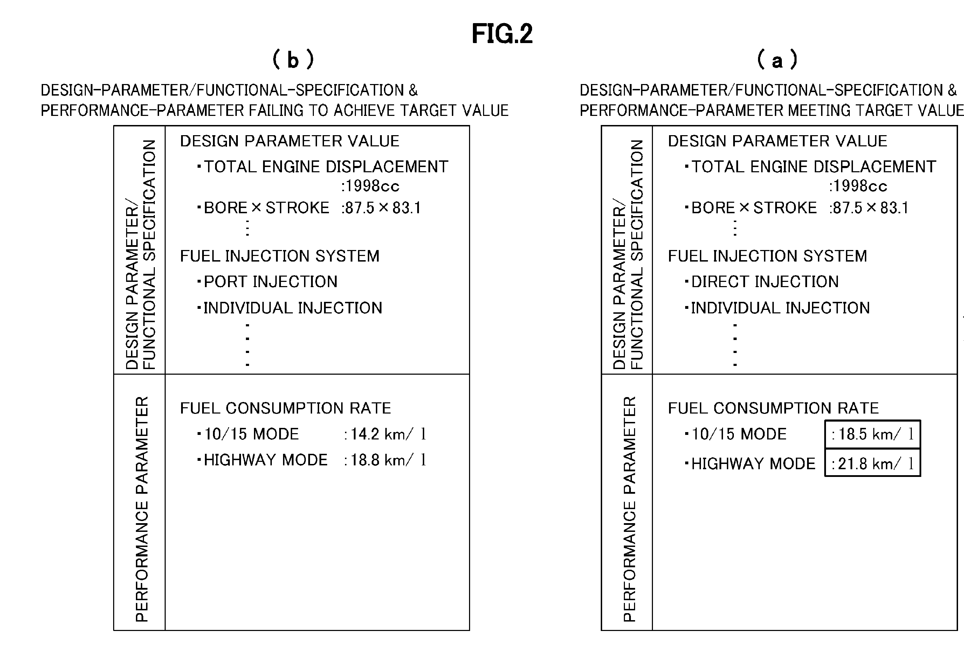

FIGS. 2(a) and 2(b) show an example of a combination of a design parameter value and a functional specification type, which is displayed on the display means 4. In an operation of presenting the combination illustrated in FIGS. 2(a) and 2(b), an engine displacement value is set at 2000 cc as a constraint or basal condition, and each of a 10/15-mode fuel consumption rate value and a highway-mode fuel consumption rate value is calculated for all combinations of design parameter values of a plurality of aforementioned design parameters, such as cylinder bore × stroke, and functional specification types of a plurality of aforementioned functional specifications, such as with/without a supercharger.

Although a plurality of design parameter values, a plurality of functional specification types and a plurality of corresponding performance parameter values are actually presented, only a value of total engine displacement and respective values of cylinder bore x stroke are shown as an example of the design parameter values, and only a type of a fuel injection system is shown as an example of the functional specification types, in FIGS. 2(a) and 2(b). Further, respective values of the 10/15-mode fuel consumption rate and the highway-mode fuel consumption rate are shown as an example of the performance parameter values, in FIGS. 2(a) and 2(b).

FIG. 2(a) shows only a top rank combination in a representation obtained by arranging the calculated performance parameter values in descending order of the 10/15-mode fuel consumption rate. FIG. 2(b) shows one example of a combination having a calculated performance parameter value on the 10/15-mode fuel consumption rate which is lower than a target fuel consumption rate value. As shown in FIG. 2(a), the value "18.5 km/l" of the 10/15-mode fuel consumption rate and the value "21.8 km/l" of the highway-mode fuel consumption rate are displayed with a frame or box surrounding therearound to indicate that each of the values meets the target fuel consumption rate value.

The combination of the design parameter values and the functional specification type of the engine model illustrated in FIG. 2(a) can be directly used as design parameter values and a functional specification type for a design-target engine to achieve the target fuel consumption rate value. For example, as seen in FIGS. 2(a) and 2(b), instead of the "port-injection type" in FIG. 2(b), the "direct-injection type" in FIG. 2(a) can be employed to achieve the target fuel consumption rate value. In this manner, a direction of engine design for achieving target performance parameter values can be readily determined to quickly proceed to a detail design stage. This makes it possible to promote the efficiency of the engine design.

While the combination of the engine model in FIGS. 2(a) and 2(b) is presented in descending order of the fuel consumption rate, it may be presented, for example, in ascending order of cost. In this case, it is desirable, for example, to select only one or more combinations capable of achieving the target fuel consumption rate value, and then arrange/present a part or all of the combinations in ascending order of cost.

The internal-combustion engine design support system according to the first embodiment has been configured under specific conditions, but various changes and modifications may be made therein. For example, while the system according to the above embodiment has been configured to perform a calculation on the fuel consumption rate, the performance parameter of the present invention is not limited to the fuel consumption rate, but may be any other performance parameter, such as a low-speed torque, a maximum torque, a maximum power or an emission performance. Further, the system according to the above embodiment has been configured to display the calculated performance parameter value meeting the target performance parameter value with a box surrounding therearound as shown in FIGS. 2(a), the system of the present invention may be configured to display the calculated performance parameter value with a different color or a different font so as to discriminate whether the calculated performance parameter value meets the target performance parameter value.

### [SECOND EMBODIMENT]

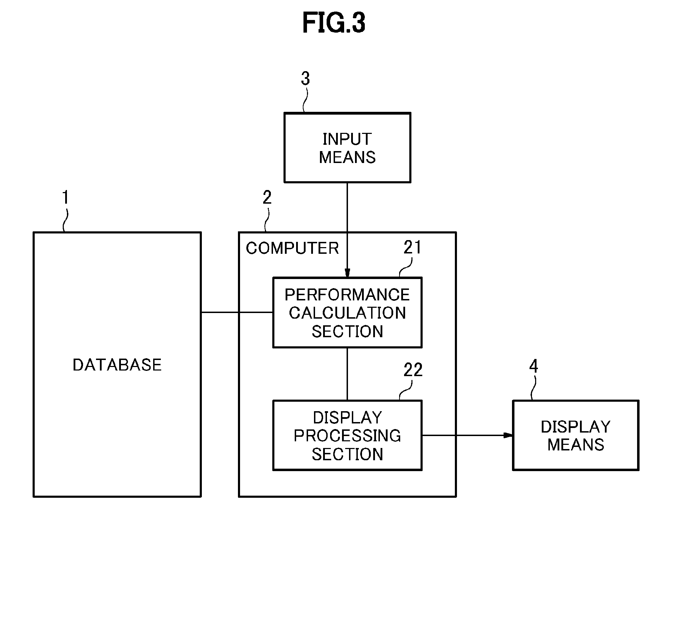

With reference to FIG. 3, the configuration of an internal-combustion engine design support system according to a second embodiment of the present invention will be described below.

As shown in FIG. 3, the internal-combustion engine design support system according to the second embodiment comprises a database 1 storing data for use in designing an engine of a vehicle, and a computer 2 for supporting the design of the engine by use of the data stored in the database 1. The computer 2 is connected to input means 3, such as a keyboard, and display means 4, such as a display.

The database 1 stores the same data as those in the first embodiment.

The computer 2 includes a performance calculation section 21 and a display processing section 23. The performance calculation section 21 and the display processing section 23 represent processing functions corresponding, respectively, to performance calculation means and combination presentation means in the internal-combustion engine design support system of the present invention. These processing functions are achieved by execution of a given program in the computer 2.

The performance calculation section 21 of the computer 2 is operable to calculate a post-change performance parameter value which is a performance parameter value corresponding to a design parameter value and a functional specification type set by changing a reference design parameter value and/or a reference functional specification type of a base engine. The base engine is selected from the existing engines by an operator through the use of the input means 3. A performance parameter value of the given performance parameter of the base engine is stored in the database 1. In an operation of calculating a post-change performance parameter value, the performance parameter value of the base engine is changed using the function formula stored in the database 1 to obtain the post-change performance parameter value.

The display processing section 23 of the computer 2 is operable to display, on the display means 4, a relation map which represents a combination of a design parameter value and a performance parameter value, or a combination of respective performance parameter value of a plurality of performance parameters, in the form of a combination of respective parameters of coordinate axes.

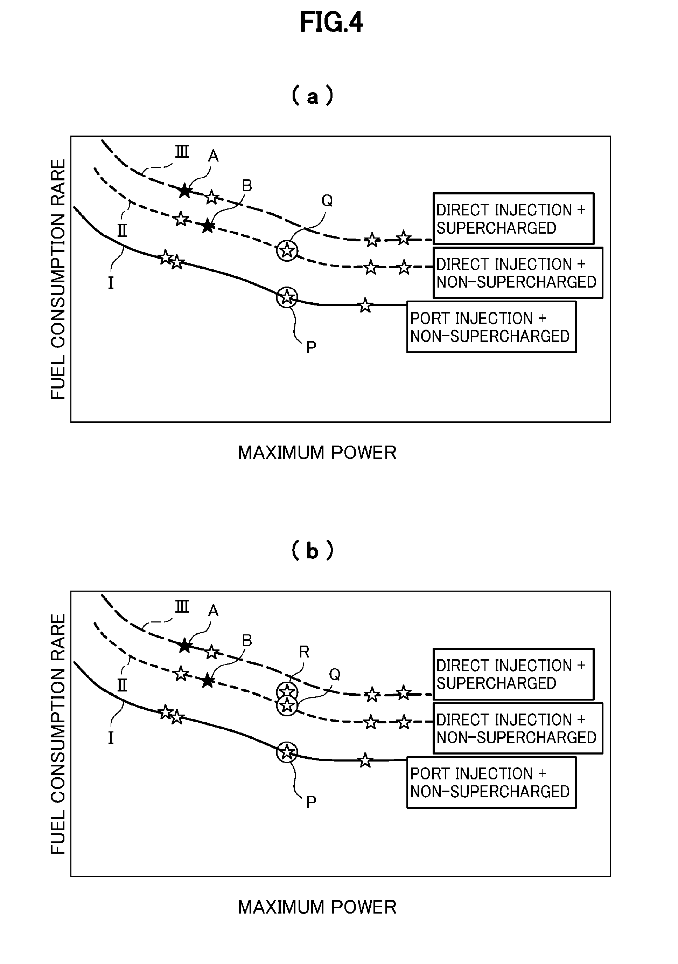

FIGS. 4(a) and 4(b) show an example of the relation map. As a combination of performance parameter values of a plurality (in the second embodiment, two) of performance parameters, the relation map illustrated in FIGS. 4(a) and 4(b) has a horizontal axis representing a maximum power as one of the performance parameters, and vertical axis representing a fuel consumption rate as the other performance parameter. In the horizontal axis, the maximum power value increases toward the right side. In the vertical axis, the fuel consumption rate value is improved toward the upper side.

A reference performance parameter value of the base engine selected from the existing engine is plotted on the relation map with a circled star mark P. This reference performance parameter value is a performance parameter value read out from the database as one of data about the base engine 1 selected by the operator through the use of the input means 3.

A target performance parameter value is also plotted on the relation map with a circled star mark Q. This target performance parameter value is set as a target value of an design-target engine by the operator through the use of the input means 3.

Further, the post-change performance parameter value calculated by the performance calculation section 21 is plotted on the relation map. Thus, a relationship of the reference performance parameter value, the post-change performance parameter value and the target performance parameter value of the design-target engine can be readily figured out based on the relation map.

In addition, each of performance parameter values of the existing engines is plotted on the relation map with a white star mark. Thus, the relationship of the reference performance parameter value, the post-change performance parameter value and the target performance parameter value of the design-target engine in a distribution of the performance parameter values of the existing engines can be readily figured out based on the relation map.

In the second embodiment, the existing engine is limited to a specific class having a given engine displacement value (e.g., 2000 cc), and the performance parameter values of the specific class of existing engines are selectively displayed on the relation map. In this manner, the design-parameter value can be specified to focus comparative existing engines on a given class of engine.

Preferably, each of the performance parameter value is plotted on the relation map after being optimized in each specification parameter type. For example, in an engine equipped with a variable valve timing (VVT) mechanism as one functional specification type, a performance parameter value of the engine may be displayed on the condition that the valve timing is optimally adjusted.

Among the plotted performance parameter values of the existing engines, a performance parameter value about an engine of a benchmark vehicle (competing vehicle) is plotted on the relation map with a black star mark [A and B in FIGS. 4(a) and 4(b)]. Specifically, in the example illustrated in FIGS. 4(a) and 4(b), as to a combination of two functional specifications, for example, a fuel injection system and with/without a supercharger, (i) a group of performance parameter values for a combination of the port injection type and the non-supercharged type are connected and indicated by a solid line I; (ii) a group of performance parameter values for a combination of the direct injection type and the non-supercharged type are connected and indicated by a broken line II; and (iii) a group of performance parameter values for a combination of the direct injection type and the supercharged type are connected and indicated by a broken line III.

In the second embodiment, an engine having a combination of the port injection type and the non-supercharged type is selected as the base engine. Thus, as shown in FIG. 4(a), the circled star mark P representing the reference performance parameter value of the base engine is plotted on the solid line I.

The circled star mark Q representing the target performance parameter value is plotted on the broken line II, as shown in FIG. 4(a). This relation map allows the operator to recognize that the combination of the functional specification types grouped by the broken line II, i.e., the combination of the direct injection type + the non-supercharged type, can be employed to achieve the target performance parameter value with a high probability. This relation map also allows the operator to recognize that the target performance parameter value can be achieved without employing the combination of the functional specification types grouped by the broken line III, i.e., the combination of the direct injection type + the supercharged type. Further, this relation map allows the operator to recognize that the target performance parameter value is hardly achieved if the base engine is not modified.

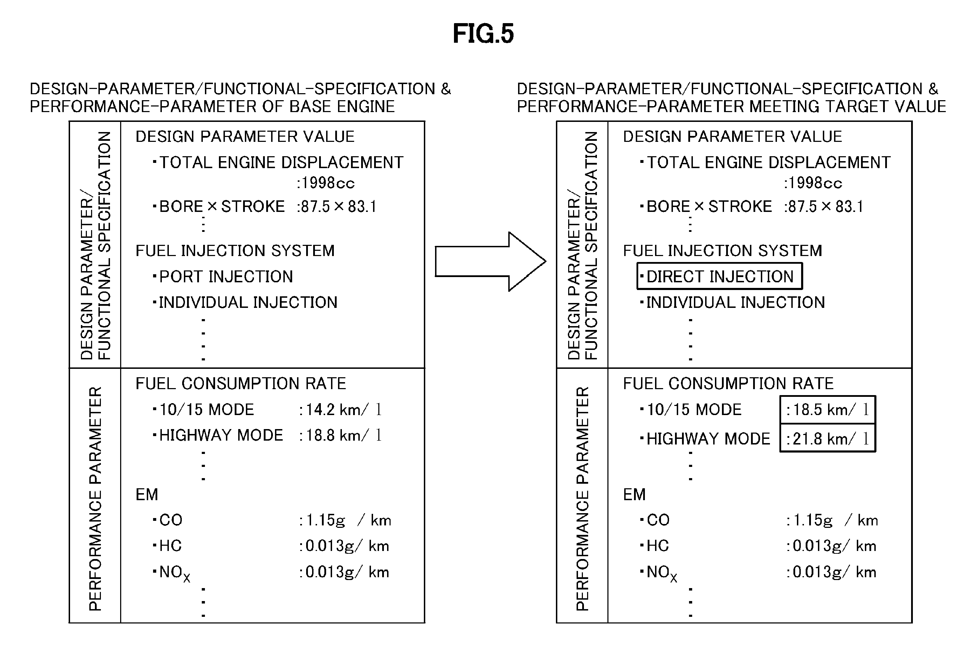

FIG. 5 shows one example of display about a design parameter value/functional specification type & performance parameter list. The left table of FIG. 5 shows one example of a design parameter value/functional specification type & performance parameter list of the base engine. The right table of FIG. 5 shows one example of a design parameter value/functional specification type & performance parameter list after a functional specification type is changed. In the second embodiment, a changed value or type is displayed with a box surrounding therearound.

Specifically, in the example illustrated in FIG. 5, a type of fuel injection system is changed from the port injection type to the direct injection type. In this case, the performance calculation section 21 is operable to calculate an impact of the change in functional specification type on the performance parameter value, using the function formula stored in the database 1. As the result of the calculation, the right table in FIG. 5 is displayed to indicate that the 10/15-mode fuel consumption rate value as one of the performance parameter values is improved from "14.2 km/l" to "18.5 km/l", and the highway-mode fuel consumption rate value as one of the performance parameter values is improved from "18.8 km/l" to "21.8 km/l".

Then, a post-change performance parameter value calculated by the performance calculation section 21 is plotted on the relation map in FIG. 4(b) with a circled star mark R. This relation map allows the operator to recognize that the combination of the functional specification types changed in the fuel injection system can provide a performance parameter value greater than the target performance parameter value, based on a position of the post-change performance parameter value on the relation map.

In the above manner, the design-target engine can be designed while verifying an impact of a change in design parameter value and/or functional specification type on a performance parameter value. Particularly, when the functional specification type is changed, a relationship between the reference performance parameter value/target performance parameter value and the post-change performance parameter value can be readily figured out with respect to a plurality of given performance parameters and/or a plurality of given design parameters. This makes it possible to promote the efficiency of the engine design.

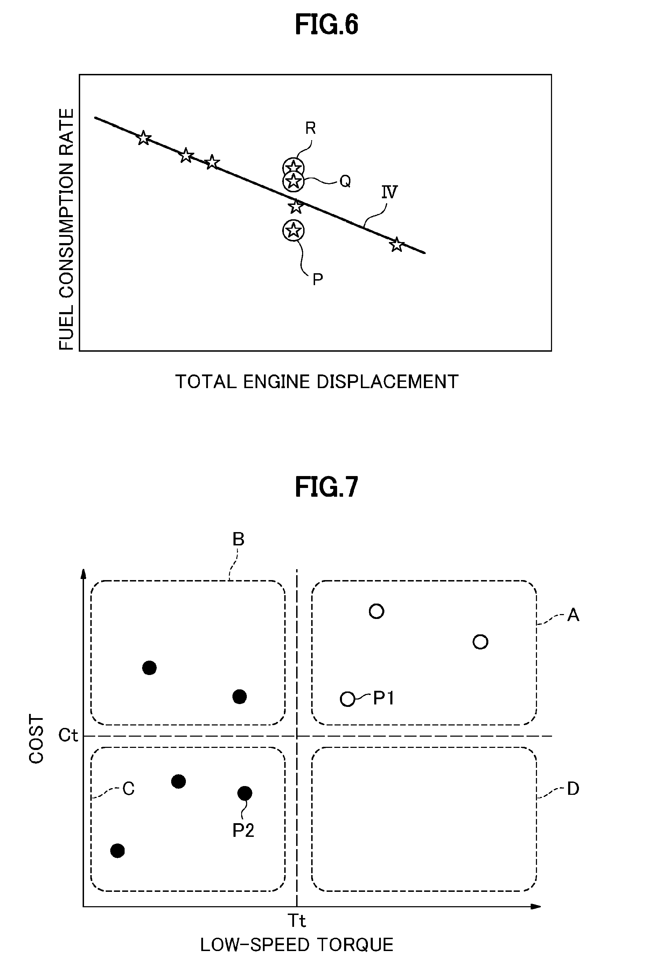

FIG. 6 shows a relation map prepared by combining a design parameter and a performance parameter in the second embodiment. This relation map has a horizontal axis representing a total engine displacement as the design parameter, and a vertical axis representing a fuel consumption rate as the performance parameter. In the horizontal axis, the total engine displacement value increases toward the right side. In the vertical axis, the fuel consumption rate value is improved toward the upper side.

In the relation map illustrated in FIG. 6, each of the performance parameter values of the existing engines is plotted with a star mark, and a linear line IV representing a distribution pattern of these performance parameter values is indicated thereon. Further, each of the reference performance parameter value P, the target performance parameter value Q and the post-change performance parameter value is plotted with a circled star mark. The relation map in FIG. 6 allows the operator to recognize that the fuel consumption rate is improved without changing the total engine displacement value. As above, the plurality of relation maps can be combined to multilaterally figure out a relationship between the design parameter value and the performance parameter value. This makes it possible to further promote the efficiency of the engine design.

The internal-combustion engine design support system according to the second embodiment has been configured under specific conditions, but various changes and modifications may be made therein. For example, the coordinate axes of the relation map may represent various combinations of different parameters. As an example, performance parameter values may be plotted on a two-dimensional coordinate plane having two coordinate axes representing a combination of two performance parameters, such as a combination of maximum torque and fuel consumption rate or a combination of maximum torque and maximum power. Alternatively, performance parameter values may be plotted on a two or three-dimensional coordinate plane having three or more coordinate axes representing a combination of three or more performance parameters.

### [THIRD EMBODIMENT]

An internal-combustion engine design support system according to a third embodiment of the present invention will be described below. Fundamentally, the internal-combustion engine design support system according to the third embodiment has the configuration illustrated in FIG. 3, as with the second embodiment.

In the third embodiment, the performance calculation section 21 of the computer 2 is operable to calculate a performance parameter value of a given performance parameter and a cost parameter value of a given cost parameter of at least one engine model set by changing a combination of a reference design parameter value and/or a reference functional specification type of a base engine selected from a plurality of existing engines. The base engine is selected from the existing engines by an operator through the use of the input means 3. For example, an engine of an existing vehicle to be remodeled as a new vehicle may be selected as the base engine.

A performance parameter value of the given performance parameter of the base engine is stored in the database 1. In an operation of calculating a performance parameter value in response to a change in design parameter value and/or performance parameter value, the performance parameter value of the base engine is changed using a function formula stored in the database 1. Further, a cost parameter value of the base engine is also stored in the database 1. The cost parameter value of the engine model may be calculated by adding/subtracting a cost variation due to the change in design parameter value and/or performance parameter value, to/from the cost parameter value of the base engine. Alternatively, the cost parameter value of the engine model may be calculated by summing respective cost parameter values of components making up the individual functional specifications of the engine model.

In the third embodiment, the display processing section 23 of the computer 2 is operable to display, on the display means 4, a relation map having two coordinate axes which represent, respectively, the given performance parameter and the given cost parameter, and the performance parameter value and the cost parameter value of the engine model calculated by the performance calculation section 21 are plotted on the relation map.

FIG. 7 shows one example of the relation map. The relation map illustrated in FIG. 7 has a horizontal axis representing a low-speed torque as the given performance parameter, and a vertical axis representing an engine cost as the given cost parameter. In the horizontal axis, the low-speed torque value increases toward the right side. In the vertical axis, the engine cost value increases toward the upper side. Further, a broken line representing a target low-speed torque value Tt, and a broken line representing a budgeted or upper-limit engine cost value Ct are indicated on the relation map.

Then, the low-speed torque value and the engine cost value of the engine model calculated by the performance calculation section 21 are plotted on the relation map. In the third embodiment, under a basal condition that an engine displacement value is set at 2000 cc, the low-speed torque value and the engine cost value are calculated for each of the engine models having various combinations of the aforementioned design parameters, such as cylinder bore x stroke, and the aforementioned functional specifications, such as with/without a supercharger.

In FIG. 7, only a part of the calculated data on the engine models are shown as an example.

In the relation map, the respective data on the engine models are indicated in such a manner that a turbocharged type and a non-turbocharged type as functional specification types of a given functional specification are discriminated from each other. Specifically, an engine model employing a turbocharger is plotted with a while circle mark, and an engine model employing no turbocharger is plotted with a black circle mark.

A design-target engine is required to have a low-speed torque value equal to or greater than the target low-speed torque value Tt, and an engine cost value equal to or less than the budgeted engine cost value Ct. As indicated by the relation map in FIG. 7, there is no plot in a region D meeting this requirement. Thus, the operator can recognize that there is no engine model satisfying the target low-speed torque value Tt and the budgeted engine cost value Ct, in this stage.

Further, from a region A of the relation map, the operator can recognize that some engine models achieve the target low-speed torque value Tt if the engine cost value is allowed to go over the budgeted engine cost value Ct. The operator can also recognize that each of the engine models plotted in the region A employs a turbocharger. That is, the operator can recognize that the target low-speed torque value Tt can be achieved by employing a turbocharger.

All of the plots in regions B, C of the relation map are indicated by the black circle mark. Thus, the operator can recognize that each of the engine models failing to achieve target low-speed torque value Tt does not employ a turbocharger.

As above, the relation map allows the operator to figure out that, the target low-speed torque value Tt can be achieved by employing a turbocharger although the engine cost value goes over the budgeted engine cost value Ct, and the target low-speed torque value Tt is hardly achieved without employing a turbocharger. Thus, this relation map can be used as an objective/technical criterion for determining whether a turbocharger should be employed.

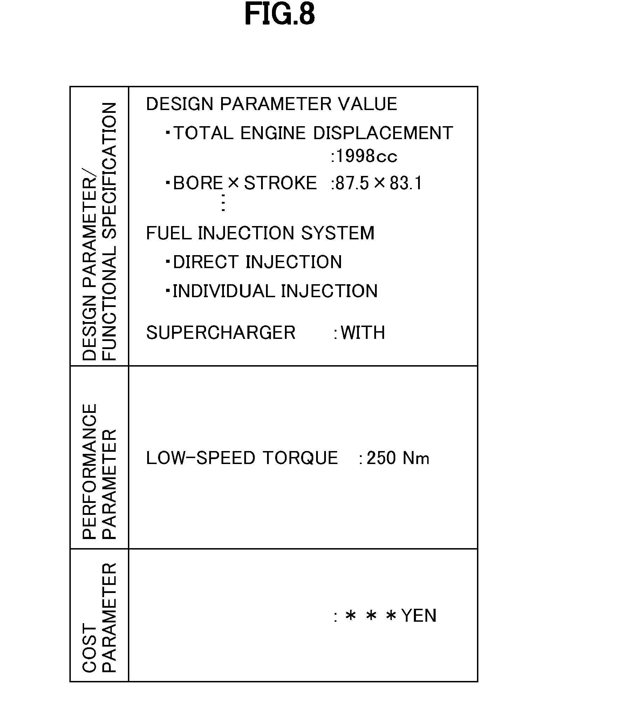

Further, the operator can select one of the plots on the relation map to display a combination of design parameter values and functional specification types of the engine model corresponding to the selected plot. FIG. 8 shows one example of display about a combination of design parameter values and functional specification types of the engine model corresponding to a plot P1 on the relation map in FIG. 7. Although a plurality of design parameter values, a plurality of functional specification types and a plurality of corresponding performance parameter values are actually indicated on the relation map, only a value of total displacement and respective values of cylinder bore x stroke are shown as an example of the design parameter values, and only a supercharged/non-supercharged type is as an example of the functional specification types, in the example illustrated in FIG. 8. Further, a calculated low-speed torque value and a calculated engine cost value are indicated.

The combination of the design parameter values and the functional specification type of the engine model illustrated in FIG. 8 can be directly used as design parameter values and a functional specification type for the design-target engine to achieve the target low-speed torque value. In this manner, a direction of engine design for achieving target performance parameter values can be readily determined. This makes it possible to quickly proceed to a detail design stage so as promote the efficiency of the engine design.

The internal-combustion engine design support system according to the third embodiment has been configured under specific conditions, but various changes and modifications may be made therein. For example, while the system according to the third embodiment has been configured to perform a calculation on the low-speed torque, the performance parameter of the present invention is not limited to the low-speed torque, but may be any other performance parameter, such as a fuel consumption rate, a maximum torque, a maximum power or an emission performance. Further, the system according to the third embodiment has been configured to discriminate whether a specific functional specification type is employed, by the black circle mark and the while circle mark, the system of the present invention may be configured to discriminate whether one or more specific functional specification types are employed, by plots each having a different shape or a different combination of shape and color.

### [FOURTH EMBODIMENT]

An internal-combustion engine design support system according to a fourth embodiment of the present invention will be described below. Fundamentally, the internal-combustion engine design support system according to the fourth embodiment has the configuration illustrated in FIG. 3, as with the second embodiment.

In the fourth embodiment, the performance calculation section 21 of the computer 2 is operable to calculate a post-change performance parameter value which is a performance parameter value corresponding to a design parameter value and a functional specification type set by changing a reference design parameter value and/or a reference functional specification type of a base engine. Firstly, an operator selects the base engine from a plurality of existing engines using of the input means 3. Then, a design parameter value of a given design parameter and a performance parameter value of a given performance parameter of the base engine is read from the database 1 to the computer 2. In a process of designing a design-target engine, the performance calculation section 21 is operable to calculate a post-change performance parameter value, i.e., a performance parameter value corresponding to a combination of a reference design parameter value and/or a reference functional specification type which are changed. In an operation of calculating the post-change performance parameter value, the reference performance parameter value of the base engine is changed using a function formula stored in the database 1 to obtain the post-change performance parameter value.

The display processing section 23 of the computer 2 is operable to display, on the display means 4, a radar chart having a plurality of coordinate axes which represent a plurality of performance parameters, respectively. The post-change performance parameter value calculated by the performance calculation section 21 is plotted and presented on the radar chart.

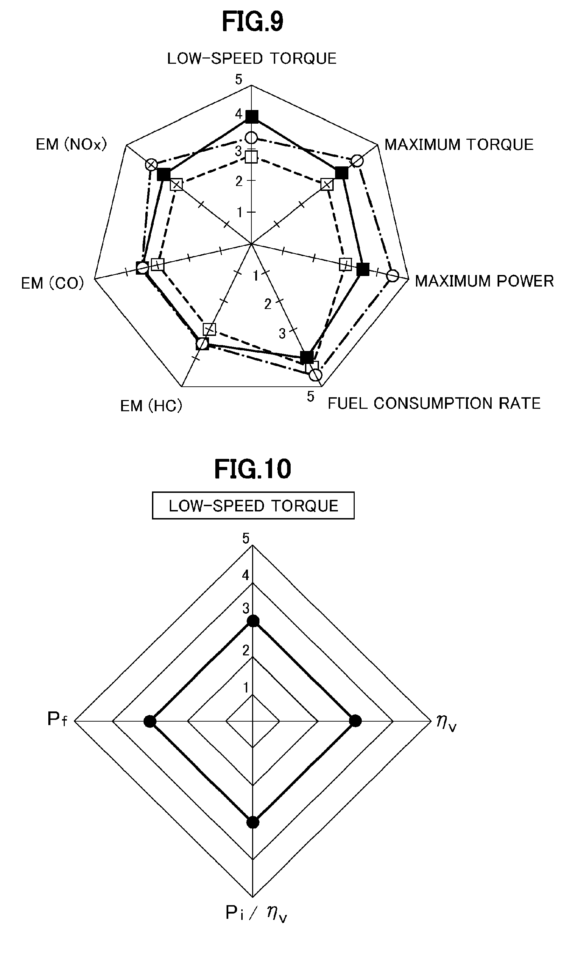

FIG. 9 shows one example of the radar chart. The radar chart in FIG. 2 has seven coordinate axes representing "low-speed torque", "maximum torque", "maximum power", "fuel consumption rate", "nitrogen oxides (NOx) emission", " carbon monoxide (CO) emission" and "hydrocarbon (HC) emission", respectively.

In each of the coordinate axes, the performance parameter value of each of the performance parameters is indicated as a relative evaluation value on a scale of one to five. For example, the performance parameter value may be rated on a scale of one to five by obtaining a distribution of performance parameter values of engines of a plurality of existing vehicles or competing vehicles (benchmark vehicles), dividing the distribution into five ranks to correlate between the performance parameter value and the relative evaluation value. More preferably, in anticipation of future upgrade in engine performance, an upper limit of the distribution of performance parameter values may be raised.

On the radar chart in FIG. 9, the performance parameter values for the seven evaluation items of the selected base engine are plotted with while square marks connected by a broken line. Further, for the purpose of comparison, seven target performance parameter values corresponding to the respective performance parameters are plotted with while circle marks connected by a one-dot chain line.

In response to operator's setup of a design parameter value and/or a functional specification type changed from a reference design parameter value and/or a reference functional specification type of the base engine, the performance calculation section 21 calculates a post-change performance parameter value as a performance parameter value after the change. For example, an engine displacement value is fixed, and dimensions, i.e., configuration, of an intake port, and/or a value of a valve lift, are modified to change the design parameter values and others of the base engine.

The change of the design parameter value may be performed, for example, by input a numerical value directly through a keyboard or the like. The change of the functional specification type, such as supercharged/non-supercharged type or a type of a fuel injection system, may be performed by displaying a list of functional specification types stored in the database 1 and selecting one or more of them from the list.

Then, the display processing section 23 plots, on the radar chart, the post-change performance parameter values calculated by the performance calculation section 21, with black square marks connected by a solid line.

Based on the example illustrated in FIG. 9, the operator can recognized that, while a post-change low-speed torque value (black square mark) is increased to far exceed a target low-speed torque value (white circle mark) as the result of the change, a post-change fuel consumption rate value (black square mark) is slightly lowered from a pre-change fuel consumption rate value (white square mark). The operator can also recognized that a post-change maximum torque value and a post-change maximum power value (black square marks) are increased from corresponding pre-change values (white square marks).

As above, in this embodiment, a calculation result on respective performance parameter values of a plurality of performance parameters changed due to a change in design parameter value or the like is indicated on the radar chart individually. This makes it possible to figure out an impact of a change in design parameter value and/or functional specification type of the design-target engine on a balance between the performance parameter values, readily and visually.

Further, in the fourth embodiment, the display processing section 23 is operable to display, for each of the coordinate axes of the above radar chart (i.e., top-layer radar chart), a second-layer radar chart having a plurality of coordinate axes which represent, respectively, a plurality of detailed-performance parameters having an impact on the performance parameter value on the coordinate axis.

FIG. 10 shows a second-layer radar chart about "low-speed torque" as one of the performance parameters on the coordinate axes of the top-layer radar chart in FIG. 9. The second-layer radar chart in FIG. 10 has coordinate axes representing, respectively, "charging efficiency ηv", "indicated mean effective pressure Pi/charging efficiency ηv" and "mechanical resistance loss Pf" as detailed-performance parameters having an impact on a low-speed torque value.

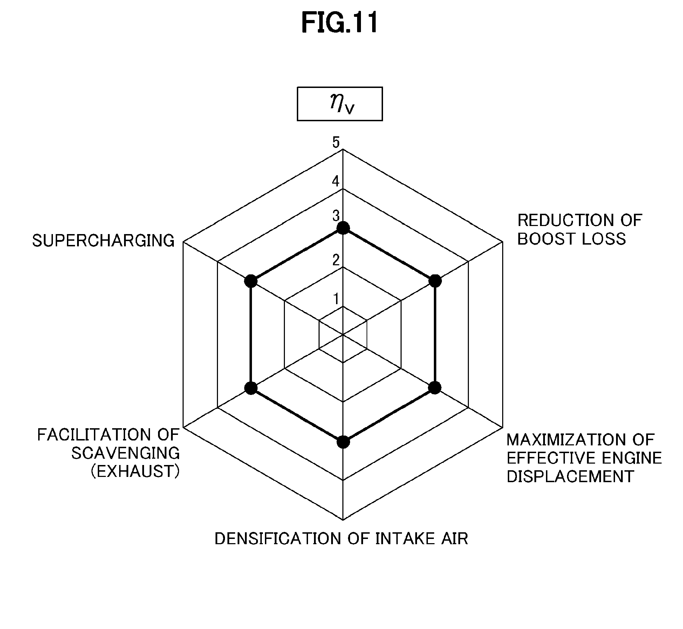

FIG. 11 shows a third-layer radar chart for the "charging efficiency ηv" as one of the detailed-performance parameters on the coordinate axes of the second-layer radar chart in FIG. 10. The third-layer radar chart in FIG. 11 has coordinate axes representing, respectively, "reduction of boost loss", "maximization of effective engine displacement", "densification of intake air", "facilitation of scavenging (exhaust)" and "supercharging" as detailed-performance parameters having an impact on a level of the "charging efficiency ηv".

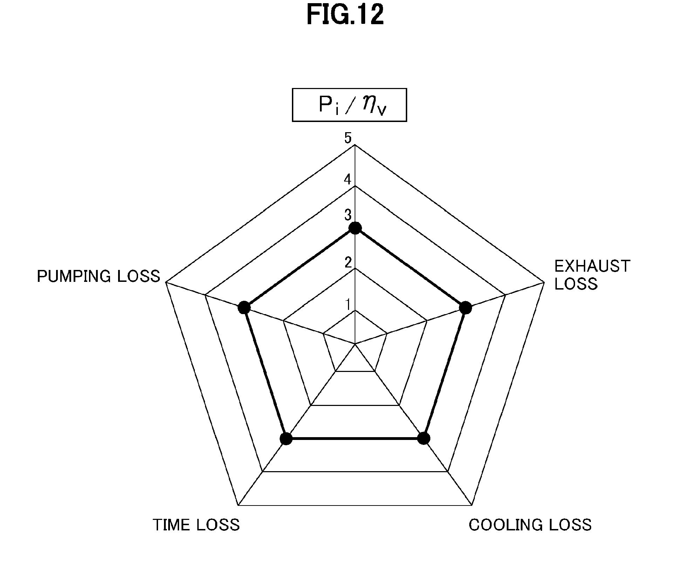

FIG. 12 shows another third-layer radar chart for the "indicated mean effective pressure Pi/charging efficiency ηv" as one of the detailed-performance parameters on the coordinate axes of the second-layer radar chart in FIG. 10. The third-layer radar chart in FIG. 12 has coordinate axes representing, respectively, "exhaust loss", "cooling loss", "time loss" and "pumping loss" as detailed-performance parameters having an impact on a level of the "indicated mean effective pressure Pi/charging efficiency ηv".

FIGS. 10 to 12 show examples where the performance parameter value of each of the detailed-performance parameters for (the) is plotted at "3" in a relative evaluation value on a scale of one to five, for the sake of simplicity. Preferably, a third-layer radar chart having coordinate axes representing, respectively, detailed-performance parameters having an impact on a level of the "mechanical resistance loss Pf" as one of the detailed-performance parameters on the coordinate axes of the second-layer radar chart in FIG. 10. In this manner, a lower-layer radar chart can be displayed with respect to each of the performance parameter to readily figure out a balance between the detailed-performance parameters.

In response to a change of a performance parameter value of the detailed-performance parameter on either one of the coordinate axes of the third-layer radar chart in FIG. 12 due to a change in design parameter value or the like, the performance calculation section 21 is operable to calculate a post-change performance parameter value of a performance parameter to be affected by the change of the performance parameter value of the detailed-performance parameter.

For example, in response to a change in design parameter value, such as dimensions/configuration of an intake manifold, dimensions/configuration of an intake port, a value of valve lift, a length of a throat or the configuration of an intake valve, a post-change evaluation value about the "reduction of boost loss" of the third-layer radar chart in FIG. 11 is calculated. Then, the display processing section 23 is operable to indicate the post-change evaluation value on the third-layer radar chart in FIG. 11.

Subsequently, the performance calculation section 21 is operable to calculate a post-change performance parameter value of the "charging efficiency ηv", as one of the evaluation items of the second-layer radar chart in FIG. 10, to be affected by the change in the "reduction of boost loss". Further, the display processing section 23 is operable to indicate the post-change performance parameter value on the third-layer radar chart in FIG. 10.

Further, the performance calculation section 21 is operable to calculate a post-change performance parameter value of the "low-speed torque", as one of the evaluation items of the top-layer radar chart in FIG. 9, to be affected by the change in the "charging efficiency ηv". Further, the display processing section 23 is operable to indicate the post-change performance parameter value on the top-layer radar chart in FIG. 9.

When the performance parameter value of the detailed-performance parameter on the lower-layer radar chart is changed, an impact of the change generally reach two or more of the evaluation items in the upper layer radar chart. For example, when the performance parameter value of the "charging efficiency ηv" is changed, an impact of the change reaches not only the "low-speed torque" but also, for example, the "fuel consumption rate", in the top-layer radar chart. In this case, the performance calculation section 21 is also operable to calculate a post-change performance parameter value of the fuel consumption rate, and the display processing section 23 is operable to indicate the post-change performance parameter value. The scores of the performance parameter value on at least one of the coordinate axes in each of the radar charts may be restricted in a given range.

As above, the performance parameter values in the upper-layer radar chart can be indicated in conjunction with a change in the performance parameter value of the detailed-performance parameter in the lower-layer radar chart to readily figure out not only a balance between the performance parameter values of the detailed-performance parameters but also a balance between the performance parameter values of the performance parameters in the upper-layer radar chart.

Further, in the fourth embodiment, the performance calculation section 21 is also operable, when the performance parameter value of the performance parameter on at least one of the coordinate axes of the top-layer radar chart, to calculate a post-change performance parameter value of the detailed-performance parameter to be affected by the change in the performance parameter value of the performance parameter. In this case, the display processing section 23 is operable to indicate the post-change performance parameter value on the lower-layer radar chart.

For example, when the performance parameter value of the "lower-speed torque" in the top-layer radar chart in FIG. 9 is changed by the operator, the performance calculation section 21 is operable to calculate respective post-change performance parameter values of the "charging efficiency ηv", "indicated mean effective pressure Pi/charging efficiency ηv" and "mechanical resistance loss Pf" of the second-layer radar chart in FIG. 10, to be affected by the change in the performance parameter value of the "lower-speed torque". Then, the display processing section 23 is operable to indicate the post-change performance parameter values on the radar chart in FIG. 10.

Subsequently, respective post-change performance parameter values of detailed performance characters on lower-layer radar charts, such as the third-layer radar charts in FIGS. 11 and 12, to be affected by the change in the "charging efficiency ηv", "indicated mean effective pressure Pi/charging efficiency ηv" and "mechanical resistance loss Pf" are calculated and indicated.

As to a pattern of the impact on the detailed-performance parameters in the lower-layer radar charts, there may be a plurality of combinations. An order of priority in the combinations may be pre-determined depending on the rate of contribution. Alternatively, post-change performance parameter values for all possible combinations may be thoroughly calculated one-by-one, and the calculated post-change performance parameter values are filtered according to a given condition. For example, the calculated post-change performance parameter values may be ranked in ascending order of engine cost value, and one combination placed at a top rank may be selected.

As above, the performance parameter values of the detailed-performance parameters of the lower-layer radar charts can be changed in conjunction with a change of the performance parameter value in the top-layer radar chart to readily figure out not only a balance between the performance parameter values of the performance parameters in the top-layer radar chart including a changed performance parameter value but also a balance between the performance parameter values of the detailed-performance parameters in each of the lower-layer radar charts associated with the performance parameters.

The internal-combustion engine design support system according to the fourth embodiment has been configured under specific conditions, but various changes and modifications may be made therein. For example, the parameter on each of the coordinate axes is not limited to that illustrated in FIGS. 9 to 12, but various other parameters may be used. For example, a second-layer radar chart associated with the "fuel consumption rate" may have coordinate axis representing "mechanical resistance loss Pf' and "indicated mean effective pressure Pi/charging efficiency ηv", respectively. A third-layer radar chart associated with the "mechanical resistance loss Pf' in this second-layer radar chart may have coordinate axes classified by a plurality detailed items, such as "valve drive system", "piston system", "crankshaft system" and "engine auxiliaries".

Further, while the fourth embodiment had been described based on an example where the radar charts are configured as a three-layered structure, the number of layers in the present invention is not limited to three. For example, the radar chart may be displayed in a configuration having a single or two layers, or may be displayed in a configuration having four or more layers.

## Claims

1. An internal-combustion engine design support system comprising:
a database (1) storing data about a design parameter value of a given design parameter, a functional specification type of a given functional specification, and a performance parameter value of a given performance parameter, which are associated with each of a plurality of existing internal-combustion engines;
performance calculation means (21) for calculating a performance parameter value of said given performance parameter of at least one of an internal-combustion engine model set by changing a combination of a reference design parameter value and/or a reference functional specification type of a base internal-combustion engine selected from said existing internal-combustion engines; and
combination presentation means (22, 23) for outputting at least one combination of a design parameter value and a functional specification type of said internal-combustion engine model having the performance parameter value calculated by said performance calculation means, according to a given presentation condition.

2. The internal-combustion engine design support system according to claim 1, wherein said given functional specification stored as the functional specification type in said database (1) includes at least one selected from the group consisting of with/without a supercharger, a fuel injection system, standard fuel, with/without a variable valve control mechanism, a valve drive mechanism and the number of intake/exhaust valves.

3. The internal-combustion engine design support system according to claim 1 or 2, wherein said given design parameter stored as the design parameter value in said database (1) includes engine displacement.

4. The internal-combustion engine design support system according to either one of claims 1 to 3, wherein said performance calculation means (21) is operable to calculate a performance parameter value of said given performance parameter for all combinations of a plurality of design parameter values of said given design parameter and a plurality of functional specification types of said given functional specification, under a given constraint condition.

5. The internal-combustion engine design support system according to either one of claims 1 to 4, wherein said given performance parameter to be calculated by said performance calculation means (21) includes fuel consumption rate.

6. The internal-combustion engine design support system according to either one of claims 1 to 5, wherein said given presentation condition for said combination presentation means (22, 23) includes presentation in ascending order of cost and presentation in descending order of performance parameter value.

7. The internal-combustion engine design support system according to either one of claims 1 to 6, wherein said combination presentation means (22, 23) is operable to selectively present only a combination of a design parameter value and a functional specification type of said internal-combustion engine model which has a performance parameter value meeting a target performance parameter value, or to present a combination of a design parameter value and a functional specification type of said internal-combustion engine model, internal-combustion engine models, with discrimination whether a performance parameter value of said combination meets a target performance parameter value.

8. The internal-combustion engine design support system according to either one of claims 1 to 7, wherein said combination presentation means (22, 23) is operable to display, on display means (4), a relation map which represents a combination of a design parameter value and a functional specification type, or a combination of respective performance parameter values of a plurality of performance parameters, in the form of a combination of respective parameters of coordinate axes, while plotting, on said relation map, a reference performance parameter value of said base internal-combustion engine, a target performance parameter value set out in a design-target internal-combustion engine, and the performance parameter value calculated by said performance calculation means (21).

9. The internal-combustion engine design support system according to claim 8, wherein said combination presentation means (22, 23) is operable to display said relation map while plotting thereon a performance parameter value at least one of said existing internal-combustion engines.

10. The internal-combustion engine design support system according to claim 9, wherein said combination presentation means (22, 23) is operable to display said relation map while plotting thereon a plurality of performance parameter values of said existing internal-combustion engines in such a manner that the performance parameter values are grouped on the basis of a combination of two or more functional specification types.

11. The internal-combustion engine design support system according to either one of claims 8 to 10, wherein said combination presentation means (22, 23) is operable to display said relation map in such a manner that coordinate axes thereof represent engine displacement as the design parameter and fuel consumption rate as the performance parameter, respectively.

12. The internal-combustion engine design support system according to either one of claims 8 to 10, wherein said combination presentation means (22, 23) is operable to display said relation map in such a manner that coordinate axes thereof represent maximum power as the performance parameter and fuel consumption rate as the performance parameter, respectively.

13. The internal-combustion engine design support system according to either one of claims 8 to 12, wherein said design parameter includes engine displacement.

14. The internal-combustion engine design support system according to either one of claims 1 to 13, wherein:
said performance calculation means (21) is operable to calculate a cost parameter value of a given cost parameter in addition to the performance parameter value of the given performance parameter; and
said combination presentation means (22, 23) is operable to display, on display means (4), a relation map having at least two coordinate axes which represents, respectively, said given performance parameter and said given cost parameter for each of a plurality of the internal-combustion engine models, while plotting, on said relation map, a reference performance parameter value of the given performance parameter and a cost parameter value of given cost parameter of each of said internal-combustion engine models, together with an indicator representing a target performance parameter value.

15. The internal-combustion engine design support system according to either one of claims 1 to 14, wherein said combination presentation means (22, 23) is operable to indicate, on said relation map, respective plots of said internal-combustion engine models, with discrimination whether a specific functional specification type is employed in each of said internal-combustion engine models.

16. The internal-combustion engine design support system according to either one of claims 1 to 15, wherein said combination presentation means (22, 23) is operable to indicate, on said relation map, an indicator representing a specific engine cost value.

17. The internal-combustion engine design support system according to claim 1 to 16, wherein said combination presentation means (22, 23) is operable to display, on display means (4), a radar chart having a plurality of coordinate axes which represent, respectively, a plurality of performance parameters, while plotting, on said radar chart, post-change performance parameter values calculated by said performance calculation means (21).

18. The internal-combustion engine design support system according to claim 17, wherein said combination presentation means (22, 23) is operable to indicate a target performance parameter value for each of said performance parameters, on said radar chart.

19. The internal-combustion engine design support system according to claim 17 or 18, wherein said combination presentation means (22, 23) is operable to display a lower-layer radar chart for each of said performance parameters on the coordinate axes of said radar chart serving as an upper-layer radar chart, said lower-layer radar chart having a plurality of coordinate axes which represent, respectively, a plurality of detailed-performance parameters interacting with a performance parameter value of said performance parameter.

20. The internal-combustion engine design support system according to claim 19, wherein:
said performance calculation means (21) is operable, when the performance parameter value of the performance parameter on either one of the coordinate axes of said upper-layer radar chart, to calculate respective post-change performance parameter values of the detailed-performance parameters to be affected by the change in the performance parameter value of said performance parameter; and
said combination presentation means (22, 23) is operable to indicate said calculated post-change performance parameter values on the lower-layer radar chart having the coordinate axes representing said detailed-performance parameters.

21. The internal-combustion engine design support system according to claim 19 or 20, wherein:
said performance calculation means (21) is operable, when the performance parameter value of the detailed-performance parameter on either one of the coordinate axes of said lower-layer radar chart, to calculate a post-change performance parameter value of the performance parameter to be affected by the change in the performance parameter value of said detailed-performance parameter; and
said combination presentation means (22, 23) is operable to indicate said calculated post-change performance parameter value on said upper-layer radar chart having the coordinate axes representing said performance parameters.
